# DEMANDE DE BREVET EUROPEEN

(11) **EP 1 343 015 A1**
(43) Date de publication de la demande: **10.09.2003**
(21) Numéro de dépôt: 03290422.9
(22) Date de dépôt: 21.02.2003
(51) Int. Cl.: G01R 1/073

(54) **Ensemble à éléments supports pour éléments de contact électroconducteurs**

(30) Priorité: 04.03.2002 FR 0202676
(71) Demandeur: Probest, 91105 Corbeil Essonnes Cedex (FR)
(72) Inventeur: Sabatier, André, 94190 Villeneuve-Saint-Georges (FR); Chasserieau, Claude, 91750 Chevannes (FR); Chasserieau, Vincent, 91750 Chevannes (FR)
(74) Mandataire: Flavenot, Bernard

(57) **Abrégé**

La présente invention concerne les dispositifs à connexions multiples perfectionnés pour systèmes de tests de micro-circuits électroniques

Le dispositif selon l'invention se caractérise essentiellement par le fait qu'il comporte un connecteur à broches 1 comportant une pastille 2 réalisée en un premier matériau électriquement isolant et une pluralité de broches 3, un connecteur de distribution électrique 20 comportant une plaque 21 en un second matériau électriquement isolant ayant un coefficient de dilatation thermique sensiblement identique à celui du premier matériau, une carte de circuit imprimé 30, des moyens de liaison électrique souple 40 pour relier les premières bornes de connexion 24 respectivement aux secondes bornes de connexion 32.

Application, notamment, aux tests de micro-circuits électroniques comme les puces électroniques des micro-ordinateurs, les cellules photosensibles miniatures.

## Description

La présente invention concerne les dispositifs à connexions multiples perfectionnés pour système de test de micro-circuits électroniques qui trouvent une application particulièrement avantageuse pour tester les composants électroniques comme les puces des micro-ordinateurs, les cellules photosensibles miniatures.

Ces connecteurs électriques à contacts multiples permettent de réaliser des contacts mécaniques en des endroits déterminés des composants électroniques à tester, pour assurer une liaison électrique continue entre les entrées-sorties de ces composants et celles correspondantes des appareils de tests.

On sait que les composants électroniques atteignent des dimensions de plus en plus petites et que leurs contacts électriques peuvent avoir des dimensions inférieures à trente microns avec des entraxes entre deux contacts contigus de l'ordre de quarante microns. Actuellement, pour un composant électronique du type «puce électronique », le nombre des contacts électriques répartis sur une surface de plus en plus réduite peut dépasser plusieurs centaines.

Pour pouvoir relier électriquement les entrées-sorties de ces composants électroniques avec celles des appareils utilisés pour les tester, il a donc été nécessaire de réaliser des connecteurs électriques à contacts multiples spécifiques.

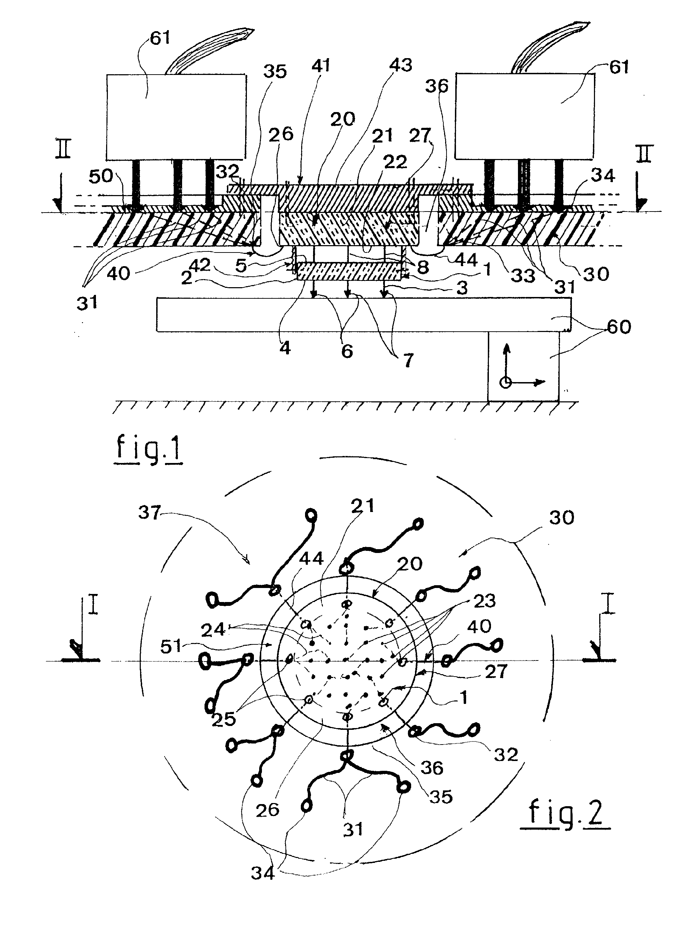

Un tel type de connecteur électrique à contacts multiples est par exemple décrit dans le FR-A-2 748 813 et le EP-A-0 802 418 et plus particulièrement illustré sur la figure 1 jointe à ce document.

Le connecteur électrique à contacts multiples décrit dans ce document antérieur comporte un corps délimitant une cavité dans laquelle sont logées trois plaques respectivement supérieure, intermédiaire et inférieure sensiblement parallèles et réalisées dans un matériau électriquement isolant.

Ces plaques comportent une multiplicité de trous traversants disposés pour être aptes à être traversés par des aiguilles de contact réalisées en un matériau électriquement conducteur, d'une longueur supérieure à la distance séparant les plaques supérieure et inférieure de sorte qu'elles émergent de part et d'autres de ces deux plaques. L'une des extrémités des aiguilles, par exemple celles émergeant de la plaque supérieure sont reliées de façon filaire aux entrées-sorties des appareils de test, tandis que le corps du connecteur est déplacé de façon que les extrémités des aiguilles émergeant de la plaque inférieure viennent au contact mécanique des entrées-sorties du composant électronique à tester.

Il existe aussi un connecteur électrique à contacts multiples ayant la forme générale d'une pastille ou analogue comportant une embase en un matériau électriquement isolant, au moins deux paires de bornes d'entrées-sorties, deux aiguilles en un matériau électriquement conducteur reliant respectivement les deux bornes d'entrées-sorties de chaque paire, une première et une deuxième plaques réalisées en un matériau électriquement isolant, ces première et deuxième plaques comportant des orifices traversants, les aiguilles étant enfichées dans ces orifices de façon qu'elles émergent par leurs extrémités de part et d'autre de ces première et deuxième plaques, les extrémités émergentes des aiguilles constituant les bornes d'entrées-sorties des deux paires, des moyens pour fixer les première et deuxième plaques par rapport à l'embase, au moins deux troisième et quatrième plaques, des moyens pour positionner ces troisième et quatrième plaques entre les première et deuxième plaques, les deuxième, troisième et quatrième plaques comportant des orifices traversants dont au moins une section transversale présente une valeur minimale sensiblement égale à la section transversale des aiguilles, ces orifices étant réalisés dans les deuxième, troisième et quatrième plaques de façon que les aiguilles soient montées coulissantes dans ces orifices, et des moyens pour commander le déplacement des troisième et quatrième plaques respectivement dans deux directions sensiblement opposées de façon à réaliser, sur chaque aiguille, deux pré-flambages en opposition de part et d'autre de sa position de repos.

Or, ces dispositifs de test doivent pouvoir de plus en plus fonctionner sur des plages de température relativement grandes, et les problèmes posés par les dilatations thermiques des différents constituants ne sont plus négligeables. En outre, les types de micro-circuits qui doivent être testés sont de plus en plus nombreux et il faut prévoir presque autant de dispositifs de test que de types de micro-circuits à tester.

La présente invention a donc pour but de réaliser un dispositif à connexions multiples perfectionné pour système de test de micro-circuits électroniques qui peut fonctionner dans des plages de température étendues et qui peut en plus s'adapter sans grandes difficultés pour tester différents types de circuits électroniques.

Plus précisément, la présente invention a pour objet un Dispositif à connexions multiples perfectionné pour système de test de micro-circuits électroniques comportant :
- un connecteur à broches comportant une pastille réalisée en un premier matériau électriquement isolant et une pluralité de broches, chaque broche étant montée en traversant la pastille de façon qu'elle émerge de part et d'autre des deux première et seconde faces opposées de la pastille, les parties de broches émergeant de la première face étant conformées en aiguilles pointues,
- un connecteur de distribution électrique comportant une plaque en un second matériau électriquement isolant, ladite plaque comportant, sur l'une de ses faces, des contacts électriques répartis en correspondance avec les extrémités des parties de broches émergeant de la seconde face de la pastille et des premières pistes électriques réunissant lesdits contacts électriques avec des premières bornes de connexion électrique, ces dites première bornes étant réparties sensiblement à la périphérie de ladite plaque,
- une carte de circuit imprimé comportant des secondes pistes électriques pour relier des deuxièmes bornes de connexion électrique situées sensiblement à proximité d'un bord de la carte avec des troisièmes bornes de connexion électrique situées en surface de ladite carte,
caractérisé par le fait que ledit second matériau a un coefficient de dilatation thermique sensiblement identique à celui du premier matériau, et qu'il comporte en outre:
- des moyens de liaison électrique souple pour relier lesdites premières bornes de connexion respectivement aux dites secondes bornes de connexion,
- des premiers moyens pour associer ledit connecteur de distribution électrique avec ladite carte de circuit imprimé, et
- des seconds moyens pour associer ledit connecteur à broches avec ledit connecteur de distribution électrique de façon que les extrémités des parties de broches émergeant de la seconde face de la pastille soient en butée respectivement contre lesdits contacts électriques.

D'autres caractéristiques et avantages de l'invention apparaîtront au cours de la description suivante donnée en regard des dessins annexés à titre illustratif mais nullement limitatif, dans lesquels :

Les figures 1 et 2 représentent le schéma de principe d'un mode de réalisation du dispositif à connexions multiples perfectionné selon l'invention pour système de test de micro-circuits électroniques, la figure 1 étant une coupe référencée I-I sur la figure 2 et la figure 2 est une coupe référencée II-II sur la figure 1.

Le mode de réalisation du dispositif à connexions multiples perfectionné pour système de test de micro-circuits électroniques, tel que schématiquement illustré sur les deux figures 1 et 2, comporte un connecteur à broches 1 comportant une pastille 2 réalisée en un premier matériau électriquement isolant et une pluralité de broches 3, chaque broche étant montée en traversant la pastille 2 de façon qu'elle émerge de part et d'autre des première et seconde faces opposées 4, 5 de la pastille 2, les parties de broches 6 émergeant de la première face 4 étant conformées en aiguilles pointues 7.

L'ensemble d'une telle pastille 2 avec les broches 3 est par exemple avantageusement constitué d'une embase en un matériau électriquement isolant, au moins deux paires de bornes d'entrées-sorties, une pluralité d'aiguilles en un matériau électriquement conducteur, constituant les broches 3, reliant respectivement les deux bornes d'entrées-sorties de chaque paire, une première et une deuxième plaques réalisées en un matériau électriquement isolant, ces première et deuxième plaques comportant des orifices traversants, les aiguilles étant enfichées dans ces orifices de façon qu'elles émergent par leurs extrémités de part et d'autre de ces première et deuxième plaques, les extrémités émergentes des aiguilles constituant les bornes d'entrées-sorties des deux paires, des moyens pour fixer les première et deuxième plaques par rapport à l'embase, au moins deux troisième et quatrième plaques, des moyens pour positionner ces troisième et quatrième plaques entre les première et deuxième plaques, les deuxième, troisième et quatrième plaques comportant des orifices traversants dont au moins une section transversale présente une valeur minimale sensiblement égale à la section transversale des aiguilles, ces orifices étant réalisés dans les deuxième, troisième et quatrième plaques de façon que les aiguilles soient montées coulissantes dans ces orifices, et des moyens pour commander le déplacement des troisième et quatrième plaques respectivement dans deux directions sensiblement opposées de façon à réaliser, sur chaque aiguille, deux pré-flambages en opposition de part et d'autre de sa position de repos.

Le dispositif comporte aussi un connecteur de distribution électrique 20 comportant une plaque 21 en un second matériau électriquement isolant, cette plaque 21 comportant, sur l'une de ses faces 22, des contacts électriques 23 répartis en correspondance avec les extrémités des parties 8 de broches 3 émergeant de la seconde face 5 de la pastille 2 et des premières pistes électriques 24 réunissant ces contacts électriques 23 avec des premières bornes de connexion électrique 25, ces premières bornes 25 étant réparties sensiblement à la périphérie 26 de la plaque 21.

Selon une caractéristique importante de l'invention, le second matériau présente un coefficient de dilatation thermique sensiblement identique à celui du premier matériau.

Dans une réalisation avantageuse, les deux premier et second matériaux sont identiques et présentent un coefficient thermique de dilatation le plus faible possible. Ces deux matériaux sont par exemple de la céramique, ce matériau présentant, outre l'avantage d'être un bon isolant électrique, l'avantage de pouvoir recevoir en surface une couche métallique conductrice sur laquelle il est possible, par gravure, de réaliser les contacts électriques 23 et les premières pistes électriques 24.

Dans une réalisation avantageuse, ces deux matériaux sont en outre choisis de façon que leur coefficient de dilatation thermique soit sensiblement identique à celui du matériau dans lequel est réalisé le micro-circuit électronique à tester. Par exemple, pour un micro-circuit en silicium, ces deux matériaux seront avantageusement de la céramique.

Le dispositif selon l'invention comporte en outre une carte de circuit imprimé 30 comportant des secondes pistes électriques 31 pour relier des deuxièmes bornes de connexion électrique 32 situées sensiblement à proximité d'un bord 33 de la carte 30 avec des troisièmes bornes de connexion électrique 34 situées en surface de la carte 30.

Cette carte de circuit imprimé 30 est constituée d'au moins une feuille de matériau électriquement isolant, par exemple une feuille de verre époxy ou analogue. Sur cette feuille sont déposées les secondes pistes électriques 31 et réalisées les deuxièmes et troisièmes bornes de connexion électrique 32, 34. Cette technique est bien connue en elle-même et ne sera donc pas plus amplement décrite ici.

Il est précisé que les deuxièmes et troisièmes bornes de connexion électrique 32, 34 peuvent traverser la feuille de matériau électriquement isolant dans laquelle est réalisée la carte 30 de façon que les secondes pistes électriques 31 puissent être sur l'une ou l'autre des deux faces de la feuille.

Enfin, le dispositif comporte des moyens de liaison électrique souple 40 pour relier les premières bornes de connexion électrique 25 respectivement aux deuxièmes bornes 32, des premiers moyens 41 pour associer le connecteur de distribution électrique 20 avec la carte de circuit imprimé 30, et des seconds moyens 42 pour associer le connecteur à broches 1 avec le connecteur de distribution électrique 20 de façon que les extrémités des parties de broches 8 émergeant de la seconde face 5 de la pastille 2 soient en butée respectivement contre les contacts électriques 23.

Dans une réalisation préférentielle, comme illustré sur les figures 1 et 2, la carte de circuit imprimé 30 a la forme d'une couronne 37 sensiblement plate, les deuxièmes bornes de connexion électrique 32 étant situées sensiblement à proximité du bord 35 de l'ouverture centrale 36 de la couronne.

Dans ce cas, la plaque 21 a la forme sensiblement d'un disque 27 dont le diamètre est inférieur au diamètre de l'ouverture centrale 36 de la couronne 37, les premiers moyens 41 pour associer le connecteur de distribution électrique 20 avec la carte de circuit imprimé 30 étant agencés de façon que le disque 27 soit sensiblement situé dans le plan de la carte de circuit imprimé 30 et centré dans l'ouverture centrale 36 de la couronne.

Avantageusement, comme la feuille de verre époxy est relativement souple, le dispositif comporte en outre un raidisseur 50, par exemple une bande métallique ou analogue, qui vient en recouvrement de la carte de circuit imprimé 30 et des moyens pour solidariser la carte de circuit imprimé avec le raidisseur. Ces moyens peuvent être de tout type : vissage , collage, sertissage, etc..

Dans une réalisation avantageuse, ces premiers moyens 41 pour associer le connecteur de distribution électrique 20 avec la carte de circuit imprimé comportent une embase 43, des moyens pour solidariser le disque 27 avec l'embase et des moyens pour solidariser l'embase 43 avec le raidisseur 50, de façon qu'un parfait découplage existe entre le connecteur de distribution électrique 20 et la carte 30, avec la présence d'un espace 51 entre le bord de ce connecteur de distribution électrique 20 et le bord 35 de l'ouverture centrale 36 de la couronne 37 permettant la dilatation thermique essentiellement de la carte 30 par rapport à la plaque de céramique 21.

Pour permettre cette dilatation thermique, les moyens de liaison électrique souple 40 pour relier les premières bornes de connexion 25 respectivement aux deuxièmes bornes de connexion 32 sont constitués par des fils 44 de matériau électriquement conducteur, la longueur de chaque fil étant supérieure à la distance séparant les première et seconde bornes à relier.

Un tel dispositif de connexions multiples perfectionné pour système de test de micro-circuits électroniques peut comporter d'autres moyens, par exemple une table à déplacement en X, Y et Z 60 sur laquelle sont situés les micro-circuits à tester, des interfaces 61 pour relier les troisième bornes de connexion électrique 34 de la carte 30 aux entrées des appareils de mesures connus sous le nom de testeurs. Ces derniers moyens sont bien connus en eux-mêmes et ne seront pas détaillés ici dans l'unique souci de simplifier la présente description.

Le dispositif selon l'invention s'utilise schématiquement de la façon suivante:
Le micro-circuit à tester est positionné sur la table 60 qui est translatée en X et/ou Y et/ou Z de façon à amener les entrées et/ou sorties du micro-circuit au contact des extrémités 6 des broches 3 conformées en aiguilles 7.
Les signaux de test émanant des testeurs sont, comme dans les dispositifs de l'art antérieur, transmis au micro-circuit via les broches, les premières pistes électriques du connecteur de distribution 20, les fils électriques 44, les secondes pistes électriques 31 de la carte de circuit imprimé 30 et les interfaces 61.

Mais le dispositif selon l'invention présente de nombreux avantages par rapport à ceux de l'art antérieur, parmi lesquels deux sont très importants

Le premier de ces avantages est le fait que, même si tout l'ensemble du dispositif est soumis à des variations de température sur une large plage, le connecteur à broches 1 et le connecteur de distribution électrique 20 ayant le même coefficient de dilatation thermique, ces deux éléments se dilatent linéairement de la même façon et n'entraînent pas de discontinuité électrique. En revanche, les différences de dilatation thermique entre le connecteur de distribution électrique 20 et la carte de circuit imprimé 30 sont absorbées par les moyens de connexion électrique souple 40, en l'occurrence les fils électriques 44 en combinaison avec l'espace 51.

Le second de ces avantages est de pouvoir tester différents types de micro-circuits en utilisant le même connecteur à broches 1 et la même carte de circuit imprimé 30. Pour adapter le dispositif au test d'un micro-circuit donné, il suffit d'utiliser un connecteur de distribution électrique 20 dont la configuration électrique est adaptée à ce micro-circuit à tester et de relier de façon adaptée les premières bornes de connexion électrique 25 aux deuxièmes bornes 32.

## Revendications

1. Dispositif à connexions multiples perfectionné pour système de test de micro-circuits électroniques comportant:
• un connecteur à broches (1) comportant une pastille (2) réalisée en un premier matériau électriquement isolant et une pluralité de broches (3), chaque broche étant montée en traversant la pastille (2) de façon qu'elle émerge de part et d'autre des deux première et seconde faces (4, 5) opposées de la pastille (2), les parties de broches (6) émergeant de la première face (4) étant conformées en aiguilles pointues (7),
• un connecteur de distribution électrique (20) comportant une plaque (21) en un second matériau électriquement isolant, ladite plaque (21) comportant, sur l'une de ses faces (22), des contacts électriques (23) répartis en correspondance avec les extrémités des parties (8) de broches (3) émergeant de la seconde face (5) de la pastille (2) et des premières pistes électriques (24) réunissant lesdits contacts électriques (23) avec des premières bornes de connexion électrique (25), ces dites première bornes (25) étant réparties sensiblement à la périphérie (26) de ladite plaque (21),
• une carte de circuit imprimé (30) comportant des secondes pistes électriques (31) pour relier des deuxièmes bornes de connexion électrique (32) situées sensiblement à proximité d'un bord (33) de la carte (30) avec des troisièmes bornes de connexion électrique (34) situées en surface de ladite carte,
**caractérisé par le fait que** ledit second matériau a un coefficient de dilatation thermique sensiblement identique à celui du premier matériau, et qu'il comporte en outre
• des moyens de liaison électrique souple (40) pour relier lesdites premières bornes de connexion (25) respectivement aux dites secondes bornes de connexion (32),
• des premiers moyens (41) pour associer ledit connecteur de distribution électrique (20) avec ladite carte de circuit imprimé (30), et
• des seconds moyens (42) pour associer ledit connecteur à broches (1) avec ledit connecteur de distribution électrique (20) de façon que les extrémités des parties de broches (8) émergeant de la seconde face (5) de la pastille (2) soient en butée respectivement contre lesdits contacts électriques (23).

2. Dispositif selon la revendication 1, **caractérisé par le fait que** lesdits premier et second matériaux électriquement isolants sont identiques.

3. Dispositif selon le revendication 2, **caractérisé par le fait que** lesdits premier et second matériaux sont de la céramique.

4. Dispositif selon l'une des revendications 1 à 3, **caractérisé par le fait que** ladite carte de circuit imprimé (30) a la forme d'une couronne (37) sensiblement plate, les deuxièmes bornes de connexion électrique (32) étant situées sensiblement à proximité du bord (35) de l'ouverture centrale (36) de ladite couronne (37).

5. Dispositif selon la revendication 4, **caractérisé par le fait que** ladite plaque (21) a la forme sensiblement d'un disque (27) dont le diamètre est inférieur au diamètre de l'ouverture centrale (36) de la couronne (37), lesdits premiers moyens (41) pour associer ledit connecteur de distribution électrique (20) avec ladite carte de circuit imprimé (30) étant agencés de façon que le disque (27) soit sensiblement situé dans le plan de la carte de circuit imprimé (30) et centré dans ladite ouverture centrale (36) de la couronne.

6. Dispositif selon l'une des revendications 1 à 5, **caractérisé par le fait qu'**il comporte un raidisseur (50) et des moyens pour solidariser ladite carte de circuit imprimé (30) avec le raidisseur.

7. Dispositif selon la revendication 6, **caractérisé par le fait que** les premiers moyens (41) pour associer ledit connecteur de distribution électrique (20) avec ladite carte de circuit imprimé (30) comportent une embase (43), des moyens pour solidariser le disque (27) avec ladite embase et des moyens pour solidariser ladite embase avec le raidisseur (50).

8. Dispositif selon l'une des revendications 1 à 7, **caractérisé par le fait que** les moyens de liaison électrique souple (40) pour relier lesdites premières bornes de connexion (25) respectivement aux dites secondes bornes de connexion (32) sont constitués par des fils (44) de matériau électriquement conducteur, la longueur de chaque fil étant supérieure à la distance séparant les première et seconde bornes à relier.

9. Dispositif selon l'une des revendications 1 à 8, **caractérisé par le fait que** lesdits premier et second matériaux ayant un coefficient de dilatation thermique sensiblement identique sont en outre choisis de façon que ce coefficient de dilatation thermique soit sensiblement identique à celui du matériau dans lequel est réalisé le micro-circuit électronique à tester.
